# EUROPÄISCHE PATENTSCHRIFT

(11) **EP 0 656 684 B1**
(45) Veröffentlichungstag und Bekanntmachung des Hinweises auf die Patenterteilung: **06.05.1999**
(21) Anmeldenummer: 94118343.6
(22) Anmeldetag: 22.11.1994
(51) Int. Cl.: H03B 5/12, G11B 5/02

(54) **Oszillatorschaltung**
Oscillator circuit
Circuit oscillateur

(30) Priorität: 03.12.1993 DE 4341228
(43) Veröffentlichungstag der Anmeldung: 07.06.1995
(73) Patentinhaber: Philips Patentverwaltung GmbH, 22335 Hamburg (DE); Koninklijke Philips Electronics N.V., 5621 BA Eindhoven (NL)
(72) Erfinder: Stacho, Reinhard, D-90471 Nürnberg (DE)
(74) Vertreter: van der Kruk, Willem Leonardus

(56) Entgegenhaltungen:
- EP-A- 0 155 743
- FR-A- 2 518 294
- PATENT ABSTRACTS OF JAPAN vol. 10, no. 15 (P-422) 21. Januar 1986 & JP-A-60 170 006 (MATSUSHITA DENKI SANGYO K.K.)
- PATENT ABSTRACTS OF JAPAN vol. 7, no. 260 (P-237) 18. November 1983 & JP-A-58 141 405 (NIPPON VICTOR COMPANY)

## Beschreibung

Die Erfindung betrifft eine Oszillatorschaltung gemäß dem Oberbegriff des Anspruchs 1.

Für Oszillatorschaltungen gibt es vielfältige Anwendungsmöglichkeiten. Beispielsweise werden Oszillatorschaltungen zur Speisung von Löschköpfen in magnetischen Aufzeichnungs- und Wiedergabegeräten verwendet. Ein Videorecorder enthält einen stationären, sich über die gesamte Breite des Bandes erstreckenden Löschkopf in Bandlaufrichtung vor der Kopftrommel, der während der Aufzeichnung eines neuen Bildsignals das Band über die ganze Breite löscht. Dieser Löschkopf wird auch mit "full erase"-Kopf bezeichnet. Außerdem ist ein stationärer Löschkopf für die parallel zur Bandkante verlaufende Längsspur für das Tonsignal vorgesehen. Es ist auch bekannt, auf der rotierenden Kopftrommel zusätzlich zu den Videoköpfen Löschköpfe vorzusehen, mit denen gezielt nur bestimmte Schrägspuren gelöscht werden können. Diese Köpfe werden auch als "flying erase"-Köpfe bezeichnet.

Eine solche Oszillatorschaltung ist aus Dokument FR-A-2 518 294 bekannt.

Bei geschalteten Oszillatoren ergeben sich insbesondere beim Ein- und Ausschalten Probleme hinsichtlich des Ein- und Ausschwingens der Oszillatorschaltung.

Aufgabe der Erfindung ist es deshalb, die sich hinsichtlich des Ein- und Ausschwingverhaltens von geschalteten Oszillatoren ergebenden Probleme mit geringem schaltungstechnischen Aufwand zu lösen.

Diese Aufgabe wird erfindungsgemäß durch die Merkmale des Anspruchs 1 gelöst.

Der Vorteil des erfindungsgemäßen Oszillators liegt insbesondere darin, daß auch bei geringem schaltungstechnischen Aufwand sauberes Ein- und Ausschwingen der Oszillatorschaltung gewährleistet ist.

Vorteilhafte Weiterbildungen gehen aus den Unteransprüchen und der nachfolgenden Beschreibung hervor. Insbesondere die Verwendung des Löschkopfes als Schwingkreisinduktivität nach Anspruch 4 hat eine wesentliche Reduzierung des Schaltungsaufwands zur Folge.

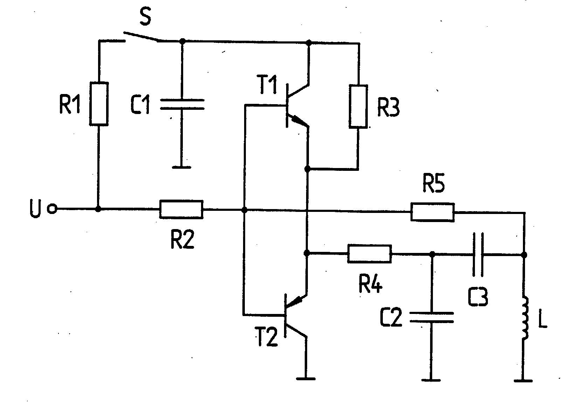

Die Erfindung wird anhand eines Ausführungsbeispiels in Verbindung mit der einzigen Figur beschrieben.

Die Oszillatorschaltung nach der Figur weist einen aus einer Reihenschaltung von Kondensatoren C2 und C3 sowie einer Induktivität L bestehenden Schwingkreis auf. Der aktive Teil der Oszillatorschaltung besteht aus einer Transistorgegentaktstufe, die von zwei Transistoren T1 und T2 gebildet wird. Transistor T1 ist vom npn-Typ, Transistor T2 vom pnp-Typ. Die Basisanschlüsse der Transistoren T1 und T2 sowie ihre Emitteranschlüsse sind jeweils miteinander verbunden. Der Kollektoranschluß von Transistor T2 ist auf Masse gelegt. Der Kollektoranschluß von Transistor T1 ist über einen Schalter S und einen Widerstand R1 mit einer die Betriebsspannung U zur Verfügung stellenden Spannungsquelle (nicht dargestellt) verbunden. Zwischen Schalter S und Kollektor von Transistor T1 ist ein auf Masse gelegter Kondensator C1 angeschlossen. Parallel zur Kollektor-Emitter-Strecke von Transistor T1 ist ein Widerstand R3 angeschlossen. Die Transistorgegentaktstufe wird von einem Widerstandsspannungsteiler R2, R5 angesteuert. Die Widerstände R2 und R5 sind dazu mit den Basisanschlüssen der Transistoren T1 und T2 verbunden. Der zweite Anschluß des Widerstandes R2 ist auf die Betriebsspannung U gelegt, der zweite Anschluß des Widerstandes R5 ist am Schwingkreis zwischen der Induktivität L und dem Kondensator C3 angeschlossen. Der Ausgang der Transistorgegentaktstufe (die verbundenen Emitter der Transistoren T1 und T2) ist über einen Widerstand R4 zwischen den Kondensatoren C2 und C3 angeschlossen.

Zum Einschalten der Oszillatorschaltung wird Schalter S betätigt, bzw. in einen leitenden Zustand gebracht. Am Kondensator C1 baut sich die Betriebsspannung U, entsprechend der sich aus dem Widerstand R1 und dem Kondensator C1 ergebenden RC-Zeitkonstante, auf. Da beim Anlegen der Betriebsspannung U an die im Sperrbetrieb (C-Betrieb) befindlichen Transistoren T1 und T2 der Gegentaktstufe kein Strom in den Schwingkreis L, C2, C3 fließen kann, ist der Widerstand R3 zur Einleitung der Schwingung notwendig. Durch den über den Widerstand R3 fließenden Strom wird der Schwingkreis angestoßen, wodurch eine Spannungsüberhöhung am Schwingkreis auftritt. Mittels des Widerstands R5 erfolgt die Mitkopplung der Gegentaktstufe an den Basisanschlüssen der Transistoren T1 und T2. Kommt eine zum Durchschalten der Transistoren T1 und T2 ausreichend hohe Spannung über den Widerstand R5 an die Basis der Transistoren T1 und T2, so liefern diese den zur Aufrechterhaltung der Schwingung des Schwingkreises L, C2, C3 nötigen Strom. Damit undefinierte Zustände der Transistoren T1 und T2 während des Einschwingens vermieden werden und damit die Übernahme kontinuierlich erfolgt, ist der ständig an der Betriebsspannung U angeschlossene Widerstand R2 eingefügt, der zusammen mit dem Widerstand R5 einen Spannungsteiler bildet.

Da die an den Emittern der Transistoren T1 und T2 anliegende Spannung zur Erreichung eines guten Wirkungsgrades der Oszillatorschaltung einen annähernd rechteckförmigen Verlauf aufweist, der Strom durch den Löschkopf aber sinusförmig sein sollte, wird ein aus dem Widerstand R4 und dem Kondensator C2 gebildeter RC-Tiefpaß eingesetzt, um den rechteckförmigen Verlauf einer Sinusschwingung anzupassen.

Da der Kondensator C2 eine wesentlich größere Kapazität als der Kondensator C3 aufweist, bestimmt im wesentlichen der Kondensator C3 zusammen mit der Induktivität L die Resonanzfrequenz des Schwingkreises L, C2, C3.

Zum Ausschalten des Oszillatorschaltung wird erneut der Schalter S betätigt, bzw. in einen nichtleitenden Zustand gebracht. Wegen der im Kondensator C1 gespeicherten Energie nimmt die Spannung am Kollektor des Transistors T1, wie oben beschrieben, nur allmählich ab. Durch den Widerstand R2 wird, wie oben beschrieben, ein kontinuierliches Ausschwingen der Oszillatorschaltung gewährleistet.

Wird die erfindungsgemäße Oszillatorschaltung zur Speisung eines Löschkopfes verwendet, ist es besonders vorteilhaft, wenn die Oszillatorindunktivität L vom Löschkopf selbst gebildet wird. Da es bekannt ist, daß für den jeweiligen Löschvorgang den Löschköpfen ein Löschwechselstrom mit einer Frequenz von etwa 70 kHz zugeführt wird und der dafür vorgesehene Löschoszillator eine Leistung von etwa 300 mW erzeugen muß, kann die dazu nötige, relativ große und teure Oszillatorspule eingespart werden.

Bei rotierenden Löschköpfen ergibt sich die zu berücksichtigende Induktivität durch die Induktivität des Löschkopfs selbst und die Induktivität des in der Kopftrommel zur Signalübertragung verwendeten Drehtransformators.

Wird die erfindungsgemäße Oszillatorschaltung zur Speisung eines Löschkopfes verwendet, so ist zu beachten, daß die Basisteilerwiderstände R2 und R5 so gewählt werden, daß der durch die Induktivität L abfließende Gleichstrom, welcher durch die Dauerspannung an R2 verursacht wird, so gering bleibt, daß es nicht zu einer unbeabsichtigten Löschwirkung kommt.

Für den Fachmann ergeben sich aus dem Beschriebenen viele Abwandlungsmöglichkeiten. Beispielsweise kann statt des in der Figur dargestellten mechanischen Schalters S ein elektronischer Schalter verwendet werden. Ebenso ist es möglich, statt der dargestellten bipolaren Transistoren Feldeffekttransistoren oder Operationsverstärker zu verwenden.

## Patentansprüche

1. Oszillatorschaltung mit einem Schwingkreis (L,C2,C3) und einem aktiven Teil, der von einer im Sperrbetrieb betriebenen Transistorgegentaktstufe (T1,T2) gebildet wird, wobei die Transistorgegentaktstufe (T1,T2) mittels eines Spannungsteilers (R2,R5) angesteuert wird,
**dadurch gekennzeichnet**,
daß der Spannungsteiler (R2,R5) ständig an einer die Betriebsspannung (U) zur Verfügung stellenden Spannungsquelle angeschlossen ist, wobei über den Spannungsteiler (R2,R5) ein Strom durch die Transistorgegentaktstufe (T1,T2) und die Induktivität (L) des Schwingkreises (L,C2,C3) fließt, und
daß die Oszillatorschaltung mittels eines Schalters (S) ein- und ausgeschaltet wird, der die Betriebsspannung (U) an der Transistorgegentaktstufe (T2,T5) schaltet.

2. Oszillatorschaltung nach Anspruch 1,
**dadurch gekennzeichnet**,
daß zur Verbesserung des Ein- und Ausschwingverhaltens der Oszillatorschaltung ein RC-Glied (R1,C1) und ein Widerstand (R3) vorhanden ist, wobei das RC-Glied (C1,R1) beim Ein- und Ausschalten eine kontinuierliche Veränderung der Betriebsspannung an der Gegentaktstufe bewirkt, und
daß bei einer für das Schalten des mit dem Schalter (S) verbundenen Transistors (T1) zu geringen Betriebsspannung an der Gegentaktstufe der Schwingkreis (L,C2,C3) über den parallel zur Kollektor-Emitter-Strecke des Transistors (T1) liegenden Widerstand (R3) zur Schwingung angeregt wird.

3. Oszillatorschaltung nach Anspruch 1 oder 2,
**dadurch gekennzeichnet**,
daß die Oszillatorschaltung zur Versorgung eines Löschkopfes in einem magnetischen Aufzeichnungs- und Wiedergabegerät verwendet wird.

4. Oszillatorschaltung nach Anspruch 3,
**dadurch gekennzeichnet**,
daß die Induktivität (L) des Schwingkreises (L,C2,C3) vom Löschkopf gebildet wird.

## Claims

1. An oscillator circuit comprising a resonant circuit (L, C2, C3) and an active part which is formed by a push-pull transistor stage (T1, T2) operated in the cutoff mode, the push-pull transistor stage (T1, T2) being driven by means of a voltage divider (R2, R5),
characterized in that
the voltage divider (R2, R5) is constantly connected to a voltage source which provides the operating voltage (U), a current flowing through the push-pull transistor stage (T1, T2) and the inductance (L) of the resonant circuit (L, C2, C3) via the voltage divider (R2, R5), and
the oscillator circuit is turned on and turned off by means of a switch (S) which applies the operating voltage (U) to the push-pull transistor stage (T2, T5).

2. An oscillator circuit as claimed in Claim 1,
characterized in that,
in order to improve the transient response of the oscillator circuit, an RC element (R1, C1) and a resistor (R3) have been provided, the RC element (C1, R1) causing the operating voltage at the push-pull stage to change continuously during turning-on and turning-off, and
the resonant circuit (L, C2, C3) being excited into resonance via the resistor (R3) arranged in parallel with the collector-emitter junction of the transistor (T1) when the operating voltage at the push-pull stage is too low for switching the transistor (T1) connected to the switch (S).

3. An oscillator circuit as claimed in Claim 1 or 2,
characterized in that
the oscillator circuit is used for driving an erase head in a magnetic recording and reproducing apparatus.

4. An oscillator circuit as claimed in Claim 3,
characterized in that
the inductance (L) of the resonant circuit (L, C2, C3) is formed by the erase head.

## Revendications

1. Circuit oscillateur doté d'un circuit résonant (L, C2, C3) et d'une partie active, qui est formée par un montage symétrique fonctionnant en mode bloqué, dans lequel le montage symétrique (T1, T2) est commandé au moyen d'un diviseur de tension (R2, R5), caractérisé en ce que le diviseur de tension (R2, R5) est connecté en permanence à une source de tension mettant à disposition la tension de fonctionnement (U), sachant que, via le diviseur de tension (R2, R5), un courant circule à travers le montage symétrique (T1, T2) et l'inductance (L) du circuit résonant (L, C2, C3), et en ce que le circuit oscillateur est mis en marche et coupé au moyen d'un interrupteur (S), qui commute la tension de fonctionnement (U) aux bornes du montage symétrique (T2, T5).

2. Circuit oscillateur suivant la revendication 1, caractérisé en ce que afin d'améliorer le comportement du circuit oscillateur à la montée et à l'amortissement, un élément RC (R1, C1) et une résistance (R3) sont présents, dans lequel l'élément RC (C1, R1) provoquent une modification continue de la tension de fonctionnement aux bornes du montage symétrique lors de la mise en marche et de la coupure, et en ce que, dans le cas d'une tension de fonctionnement aux bornes du montage symétrique trop faible pour commuter le transistor (T1) connecté à l'interrupteur (S) , le circuit résonant (L, C2, C3) est amené à l'oscillation par l'intermédiaire de la résistance (R3) en parallèle avec le trajet collecteur-émetteur du transistor (T1).

3. Circuit oscillateur suivant la revendication 1 ou 2, caractérisé en ce que le circuit oscillateur est utilisé pour alimenter une tête d'effacement dans un appareil d'enregistrement et de reproduction magnétique.

4. Circuit oscillateur suivant la revendication 3, caractérisé en ce que l'inductance (L) du circuit résonant (L, C2, C3) est formée par une tête d'effacement.
